# EUROPEAN PATENT SPECIFICATION

(11) **EP 1 435 621 B1**
(45) Date of publication and mention of the grant of the patent: **11.07.2007**
(21) Application number: 02425809.7
(22) Date of filing: 30.12.2002
(51) Int. Cl.: G11C 5/14, G11C 16/30, H02M 3/07

(54) **Power voltage supply distribution architecture for a plurality of memory modules**
Versorgungsarchitektur für die Einspeisespannung von mehreren Speichermodulen
Architecture de distribution de tensions d'alimentation pour une pluralité de modules de mémoire

(43) Date of publication of application: 07.07.2004
(73) Proprietor: STMicroelectronics S.r.l., 20041 Agrate Brianza (Milano) (IT)
(72) Inventor: Pasotti, Marco, 27028 S. Martino Siccomario (Pavia) (IT); De Sandre, Guido, 20047 Brugherio (Milano) (IT); Iezzi, David, 23875 Osnago (Lecco) (IT); Muzzi, Gilberto, 23880 Olgiate Molgora (Lecco) (IT); Poles, Marco, 25016 Ghedi (Brescia) (IT)
(74) Representative: Ferrari, Barbara

(56) References cited:
- US-A1- 2001 014 039
- US-A1- 2002 141 238
- US-B1- 6 349 063
- US-B1- 6 434 044

## Description

### Field of application

The present invention relates to a power voltage supply distribution architecture for a plurality of memory modules.

More specifically, the invention relates to an architecture for distributing supply voltages to a plurality of memory modules supplied through a plurality of charge pump circuits.

The invention relates particularly, but not exclusively, to an architecture for distributing supply voltages to a plurality of Flash memory modules and the following description is made with reference to this field of application for convenience of illustration only.

### Prior art

As it is well known, for the correct operation of a Flash non volatile memory it is necessary to generate a plurality of voltages, starting from a same supply voltage reference Vdd. In particular, to perform correctly the different operations (reading, programming, erasing) on Flash memory cells, some voltages in this plurality of voltages must have a higher value than the supply voltage Vdd, while other voltages must have even negative values, i.e. values being lower than a ground voltage reference GND, corresponding to a void voltage value.

In order to increase memory performances it is also well known the fact of splitting the memory in several banks or modules and of performing in parallel some of these operations (reading, programming, erasing) on different banks.

Particularly, memory architectures capable of performing a reading operation on different banks are known. Said memory architectures are described for example in US patents no. 5,691,955 in the name of Mitsubishi Electric and no. 5,684,752 in the name of Intel.

Memory architectures capable of performing in parallel reading and programming operations are also known, as described in US patents no. 5,245,572 in the name of Intel and no. 5,867,430 in the name of Chen et al. Particularly, the memory architecture described in the patent in the name of Chen et al. is also capable of performing in parallel reading and erasing operations.

All the proposed known solutions have however major limitations.

First of all, by using known memory architectures it is not possible to perform in parallel programming and erasing operations. Moreover, these architectures are not capable of managing more than two parallel operations.

Finally, none of the known architectures is capable of managing requests coming from a number of banks being different from the number conceived in the architecture designing step, unless the hardware structure of the architecture itself is changed.

The technical problem underlying the present invention is to provide an architecture for distributing supply voltages to a non volatile memory, particularly of the Flash type and organised in memory modules, capable of generating different voltages needed for the correct operation of the memory itself, ensuring in the meantime a total parallelism between the reading, programming and erasing operations to be performed on memory cells and a correct management of a plurality of requests coming from different memory modules, thus overcoming the limitations currently affecting the architectures according to the prior art.

US 2002/0141238 A1 discloses an architecture as indicated in the preamble of claim 1.

### Summary of the invention

The solution idea underlying the present invention is to provide an architecture for distributing supply voltages to a plurality of memory modules comprising a block for generating the voltages required for the correct operation of the memory itself which is physically and functionally separated from a block for managing the requests received from the banks included in the memory.

On the basis of this solution idea the technical problem is solved by an architecture as previously described and defined in the characterising part of claim 1.

The features and advantages of the architecture according to the invention will be apparent from the following description of an embodiment thereof given by way of non-limiting example with reference to the attached drawings.

### Brief description of the drawings

- Figure 1 schematically shows a memory device comprising an architecture for distributing supply voltages to a plurality of memory modules according to the invention;
- Figure 2 shows in greater detail the architecture for distributing supply voltages of figure 1.

### Detailed description

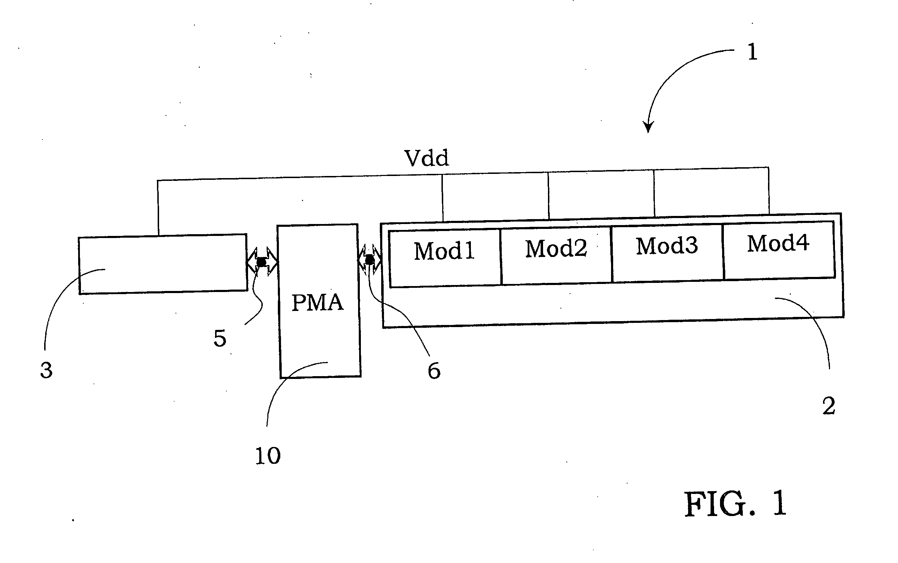

With reference to figure 1, a Flash non volatile memory device comprising a memory section 2 organised in banks or memory modules Mod1, ... ModN is globally and schematically indicated with 1.

Particularly, in the example shown, by way of non limiting example, the Flash memory section 2 comprises four memory modules indicated with Mo1, ..., Mod 4 and connected to a supply voltage reference Vdd.

The Flash memory device 1 comprises also a voltage generator block 3.

As mentioned with reference to the prior art, for the correct operation of Flash memory modules it is necessary to generate a plurality of voltages with a higher value than the supply voltage reference Vdd, which will be indicated with Vhigh1, ..., VhighN, as well as a plurality of negative value voltages, which will be indicated with Vneg1, ..., VnegN.

It is worth noting that for generating these supply voltages Vhigh1, ..., VhighN and Vneg1, ..., VnegN a plurality of charge pump circuits Pump1, ..., PumpM included in the voltage generator block 3 are generally used, each one being capable of supplying a predetermined current amount.

Advantageously according to the invention the memory device 1 comprises an arbitrator block 10 inserted between the charge pump circuits Pump1, ..., PumpM of the voltage generator block 3 and the plurality of memory modules Mod1, ..., ModN.

Particularly, the block 10 is connected to the voltage generator block 3 through a first bidirectional bus 5 and to the Flash memory section 2 through a second bidirectional bus 6.

Advantageously according to the invention, block 10 receives a plurality of requests of convenient supply voltage values or more simply power requests from memory modules and it provides to conveniently drive the charge pump circuits Pump1, ..., PumpM of the voltage generator block 3 in order to ensure correct values for the supply voltages Vhigh1, ..., VhighN and Vneg1, ..., VnegN sent to the plurality of memory modules Mod1, ..., ModN. Block 10 implements thus an architecture for distributing supply voltages generated by the plurality of charge pump circuits for the plurality of memory modules during the different operating steps of the memory device itself.

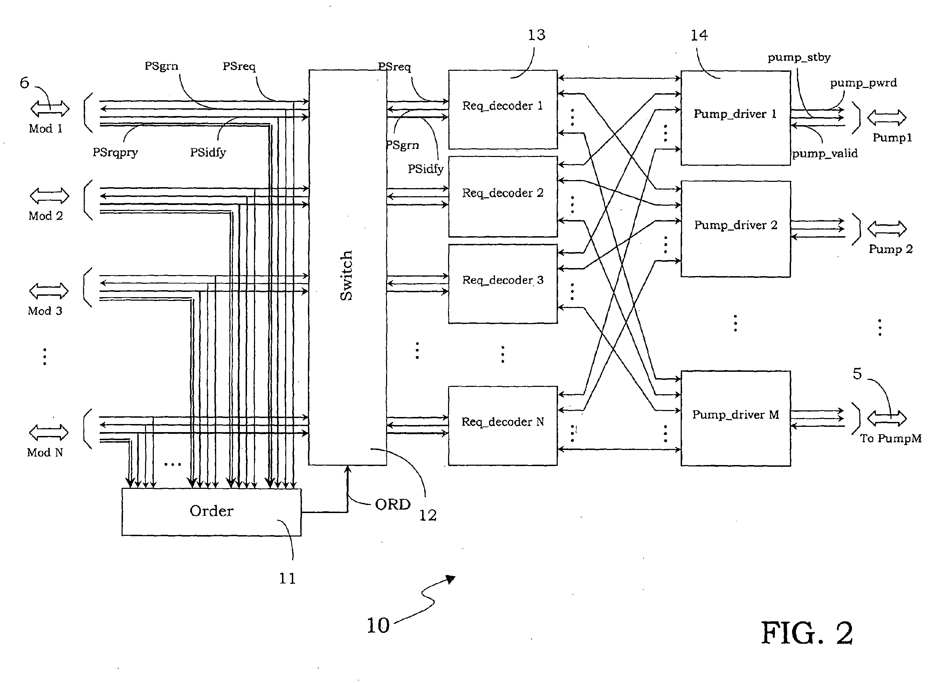

Particularly, referring to figure 2, the architecture 10 for distributing supply voltages according to the invention comprises a sorting block 11 input-connected to the second bidirectional bus 6 from which it receives a power request signal PSreq from a memory module of said plurality of modules.

The second bidirectional bus 6 comprises also:
- an identification bus PSidfy of the operation required;
- a priority bus PSrqpry of the request signal PSreq.

The sorting block 11 finally receives at its input from a switching block 12 a request allocation signal PSgrn and it outputs to the same switching block 12 a sorting signal ORD of the power requests received from the plurality of modules Mod1, ..., ModN.

The switching block 12 receives in turn the power request signal PSreq, it is connected to the identification bus PSidfy of the operation required and to the priority bus PSrqpry and it provides, through the second bidirectional bus 6, the sorting block 11 and the plurality of memory modules Mod1, ..., ModN with the request allocation signal PSgrn.

The switching block 12 is bidirectionally-connected also to a plurality of request decoders 13 to which it provides the power request signal PSreq and from which it receives the request allocation signal PSgrn. The switching block 12 is connected to the plurality of decoders 13 also through the identification bus PSidf of the operation required.

The plurality of request decoders 13 is finally connected in a multiplexed bidirectional way to a plurality of driving circuits 14, being connected in turn, through the first bidirectional bus 5, to the plurality of charge pump circuits Pump1, ..., PumpM of the voltage generator block 3 to which they provide the following signals:
- the activation signal pump_pwd of a corresponding charge pump circuit; and
- a stand-by mode signal pump_stby of a corresponding charge pump circuit.

Driving circuits 14 receive also from the plurality of charge pump circuits Pump1, ..., PumpM a validity signal pump_valid, bringing the information that the charge pump has reached the desired value.

It is possible to software-configure:
- the correspondence between the type of operation required and the charge pumps needed to satisfy it;
- power down and stand-by times; and
- number of requests which can be satisfied by each charge pump at a time.

Advantageously according to the invention, the plurality of modules ModO, ..., ModN connected to the architecture 10 for distributing supply voltages shares therefore a same plurality of charge pump circuits Pmp1, ..., PumpM for generating supply voltages Vhigh1, ..., VhighN and Vneg1, ..., VnegN needed for the correct operation of the modules themselves.

The architecture 10 for distributing supply voltages, knowing how many operation can be supported by a determined charge pump circuit, let less priority operations wait until the corresponding charge pump circuits are free.

The operation of the architecture 10 for distributing supply voltages according to the invention will now be described in greater detail.

The sorting block 11 processes the voltage requests received from the plurality of modules Mod1, ..., ModN on the basis of the following rules:
- request state (request being already active or new request);
- priority information;
- position of the module which has performed the request.

The switching block 12 identifies the requests to be satisfied on the basis of the signal received from the sorting block 11 and it spreads the corresponding signals to the plurality of request decoders 13, which enable in turn the corresponding driving circuits 14 of the charge pump circuits Pump1, ..., PumpN.

Particularly, driving circuits 14 manage the power down and stand-by conditions of the plurality of charge pump circuits Pump1, ..., PumpM.

Essentially, the architecture 10 for distributing supply voltages provides for a scheduling of the power requests received from the memory modules Mod1, ..., ModN through a priority-scale-based sorting.

In an example for implementing the sorting block 11 it is possible to consider a priority scale wherein reading operations are priority ones with respect to programming operations and programming operations are priority ones with respect to erasing operations.

Moreover, it is possible to consider, for the same operation required, that modules being closer to the architecture 10 for distributing supply voltages are considered as priority with respect to farther modules. Particularly, referring to figure 1, module Mod1 is considered as the closest and module Mod4 the farthest from the architecture 10 for distributing supply voltages.

In other words, the priority scale comprises a priority classification of the different operations (reading, writing, erasing) which can be performed on the memory cells of modules Mod1, ..., Mod4 or of the requests received from the different modules.

Advantageously according to the invention, the architecture 10 for distributing supply voltages is implemented so as to sort the requests of the plurality of independent modules (Mod1, ..., ModN) in a single stroke of the memory device 1 clock signal (having, for example, a frequency being lower than or equal to 250 MHz).

In conclusion, the architecture 10 for distributing supply voltages according to the invention can be easily implemented and it has the following advantages:
1) ensuring a total parallelism of the different operations (reading, writing, erasing) performed on the memory cells of the different modules;
2) allowing several requests received from the modules to be managed, by sorting them on the basis of a predetermined priority scale;
3) allowing a high number of modules connected to a same arbitrator to be managed;
4) allowing the priority with which operations are managed to be software-reconfigured.

Finally it is worth noting that the delay inserted by the architecture 10 for distributing supply voltages can be reduced to a single stroke of the memory device clock signal wherein it is inserted.

## Claims

1. An architecture for distributing supply voltages to a plurality of memory modules (Mod1, ..., ModN) supplied through a plurality of charge pump circuits (Pump1, ..., PumpM), comprising a sorting block (11) receiving a plurality of power requests and capable of providing a sorting signal (ORD) of said power request in order to drive said plurality of charge pump circuits (Pump1, , PumpM) and distribute convenient supply voltages (Vhigh1, ..., VhighN; Vneg1, ..., VnegN) to said plurality of memory modules (Mod1, ..., ModN),
**characterized in that** said sorting block (11) is bidirectionally-connected to said plurality of memory modules (Mod1, ..., ModN), receives said power request from said plurality of memory modules and provides said sorting signal on the basis of a priority scale.

2. An architecture for distributing supply voltages according to claim 1, **characterised in that** it comprises also a switching block (12) connected to said plurality of memory modules (Mod1, ..., ModN) through a bidirectional bus (6) and to said sorting block (11) to receive at its input said sorting signal (ORD).

3. An architecture for distributing supply voltages according to claim 2, **characterised in that** said sorting block (11) receives, though said bidirectional bus (6), a power request signal (PSreq) from a memory module of said plurality of modules (Mod1, ..., ModN) and a request allocation signal (PSgrn) and it is connected to:
- an identification bus (Psidfy) of the operation required; and
- a priority bus (Psrqpry) of the request signal (Psreq).

4. An architecture for distributing supply voltages according to claim 3, **characterised in that** said switching block (12) receives at its input said power request signals (Psreq) and it outputs said request allocation signal (PSgrn) and it is connected to said identification bus (Psidfy) and priority bus (Psrqpry).

5. An architecture for distributing supply voltages according to claim 4, **characterised in that** said switching block (12) is also bidirectionally-connected to a plurality of request decoders (13) to which it provides said power request signal (PSreq) and from which it receives said request allocation signal (PSgrn), said switching block (12) being also connected to said plurality of request decoders (13) through said identification bus (PSidfy).

6. An architecture for distributing supply voltages according to claim 5, **characterised in that** said plurality of request decoders (13) is connected in a multiplexed bidirectional way to a plurality of driving circuits (14), connected in turn, through a further bidirectional bus (5), to said plurality of charge pump circuits (Pump 1, ... , PumpM).

7. An architecture for distributing supply voltages according to claim 6, **characterised in that** said plurality of request decoders (13) provides through said further bidirectional bus (5) the following signals:
- an activation signal (pump_pwd) of a corresponding charge pump circuit; and
- a stand-by mode signal (pump_stby) of a corresponding charge pump circuit.

8. An architecture for distributing supply voltages according to claim 7, **characterised in that** said plurality of request decoders (13) receives through a further bidirectional bus (5) a validity signal (pump_valid), bringing the information that the charge pump has reached the desired value.

9. An architecture for distributing supply voltages according to claim 8, **characterised in that** said plurality of driving circuits (14) manages the power down and stand-by conditions of said plurality of charge pump circuits (Pump1, ..., PumpM) by limiting said power requests performed by each charge pump circuit under said highest value allowed.

10. An architecture for distributing supply voltages according to claim 6, **characterised in that** it is software-configurable.

11. An architecture for distributing supply voltages according to claim 1, **characterised in that** said sorting block (11) processes said power requests received from said plurality of modules (Mod1, ..., ModN) on the basis of the following rules:
- request state (request being already active or new request);
- priority information;
- position of a module which has performed said power request.

12. An architecture for distributing supply voltages according to claim 11, **characterised in that** said rules comprise a priority classification of requests received from different modules of said plurality of memory modules (Mod1, ..., ModN).

13. An architecture for distributing supply voltages according to claim 1, **characterised in that** it processes said power requests received from said plurality of memory modules (Mod1, ..., ModN) in a single stroke of a clock signal.

## Patentansprüche

1. Architektur zum Verteilen von Versorgungsspannungen an eine Mehrzahl von Speichermodulen (Mod1, ... , ModN), die über eine Mehrzahl von Ladungspumpenschaltungen (Pump1, ... , PumpM) zugeführt werden, aufweisend: einen Sortierblock (11), der eine Mehrzahl von Energie-Anforderungen erhält und in der Lage ist, ein Sortiersignal (ORD) der Energie-Anforderungen zu schaffen, um die Mehrzahl der Ladungspumpenschaltungen (Pump1, ... , PumpM) anzusteuern und angemessene Versorgungsspannungen (Vhigh1, ... , VhighN; Vneg1, ... , VnegN) an die Mehrzahl der Speichermodule (Mod1, ... , ModN) zu verteilen,
**dadurch gekennzeichnet, dass** der Sortierblock (11) mit der Mehrzahl der Speichermodule (Mod1, .., ModN) bidirektional verbunden ist, die Energie-Anforderungen von der Mehrzahl der Speichermodule erhält und das Sortiersignal auf der Basis einer Prioritätenskala bereitstellt

2. Architektur zum Verteilen von Versorgungsspannungen nach Anspruch 1, **dadurch gekennzeichnet, dass** sie ferner einen Schaltblock (12) aufweist, der mit der Mehrzahl von Speichermodulen (Mod1, ... , ModN) über einen bidirektionalen Bus (6) verbunden ist und mit dem Sortierblock (11) verbundne ist, um an seinem Eingang das Sortiersignal (ORD) zu erhalten.

3. Architektur zum Verteilen von Versorgungsspannungen nach Anspruch 2, **dadurch gekennzeichnet, dass** der Sortierblock (11) über den bidirektionalen Bus (6) ein Energie-Anforderungssignal (PSreq) von einem Speichermodul der Mehrzahl von Modulen (Mod1, ... , ModN) und ein Zuordnungssignal (PSgrn) erhält und verbunden ist mit:
- einem Identifikations-Bus (Psidfy) der erforderlichen Operation; und
- einen Prioritäten-Bus (Psrqpry) des Anforderungssignals (Psreq)

4. Architektur zum Verteilen von Versorgungsspannungen nach Anspruch 3, **dadurch gekennzeichnet, dass** der Schaltblock (12) an seinem Eingang die Energie-Anforderungssignale (Psreq) erhält und das Anforderungs-Zuordnungssignal (PSgrn) abgibt sowie mit dem Identifikations-Bus (Psidfy) und dem Prioritäten-Bus (Psrqpry) verbunden ist

5. Architektur zum Verteilen von Versorgungsspannungen nach Anspruch 4, **dadurch gekennzeichnet, dass** der Schaltblock (12) auch mit einer Mehrzahl von Anforderungs-Decodern (13) bidirektional verbunden ist, an die er das Energie-Anforderungssignal (PSreq) liefert und von denen er das Anforderungs-Zuordnungssignal (PSgrn) erhält, wobei der Schaltblock (12) durch den Identifikations-Bus (PSidfy) auch mit der Mehrzahl von Anforderungs-Decodern (13) verbunden ist

6. Architektur zum Verteilen von Versorgungsspannungen nach Anspruch 5, **dadurch gekennzeichnet, dass** die Mehrzahl der Anforderungs-Decoder (13) in bidirektionaler Multiplex-Weise mit einer Mehrzahl von Treiberschaltungen (14) verbunden ist, die wiederum durch einen weiteren bidirektionalen Bus (5) mit der Mehrzahl der Ladungspumpenschaltungen (Pump1, PumpM) verbunden sind.

7. Architektur zum Verteilen von Versorgungsspannungen nach Anspruch 6, **dadurch gekennzeichnet, dass** die Mehrzahl der Anforderungs-Decoder (13) durch den weiteren bidirektionalen Bus (5) folgende Signale liefert:
- ein Aktivierungssignal (pump_pwd) einer entsprechenden Ladungspumpenschaltung; und
- ein Standby-Modus-Signal (pump_stby) einer entsprechenden Ladungspumpenschaltung

8. Architektur zum Verteilen von Versorgungsspannungen nach Anspruch 7, **dadurch gekennzeichnet, dass** die Mehrzahl der Anforderungs-Decoder (13) über einen weiteren bidirektionalen Bus (5) ein Gultigkeits-Signal (pump_valid) erhält, das die Information liefert, dass die Ladungspumpe den gewunschten Wert erreicht hat

9. Architektur zum Verteilen von Versorgungsspannungen nach Anspruch 8, **dadurch gekennzeichnet, dass** die Mehrzahl der Treiberschaltungen (14) die Energieausschalt- und Standby-Bedingungen der Mehrzahl der Ladungspumpenschaltungen (Pump1, ..., PumpM) bewältigt, indem sie die von jeder Ladungspumpenschaltung vorgenommenen Energie-Anforderungen auf einen Wert unter dem höchsten zulässigen Wert begrenzt.

10. Architektur zum Verteilen von Versorgungsspannungen nach Anspruch 6, **dadurch gekennzeichnet, dass** sie Software-konfigurierbar ist.

11. Architektur zum Verteilen von Versorgungsspannungen nach Anspruch 1, **dadurch gekennzeichnet, dass** der Sortierblock (11) die von der Mehrzahl von Modulen (Mod1, .., ModN) erhaltenen Energie-Anforderungen auf der Basis der folgenden Regeln verarbeitet:
- Anforderungsszustand (Anforderung ist bereits aktiv oder neue Anforderung);
- Prioritäten-Information;
- Position eines Moduls, der die Energie-Anforderung vorgenommen hat

12. Architektur zum Verteilen von Versorgungsspannungen nach Anspruch 11, **dadurch gekennzeichnet, dass** die Regeln eine Prioritäten-Klassifizierung der Anforderungen aufweisen, die von verschiedenen Modulen der Mehrzahl von Speichermodulen (Mod1, ... , ModN) empfangen werden.

13. Architektur zum Verteilen von Versorgungsspannungen nach Anspruch 1. **dadurch gekennzeichnet, dass** sie die von der Mehrzahl der Speichermodule (Mod1, ... , ModN) erhaltenen Energie-Anforderungen in einem einzigen Takt eines Taktsignals verarbeitet.

## Revendications

1. Architecture de distribution de tensions d'alimentation à une pluralité de modules de mémoire (Mod1, ..., ModN) alimenté par une pluralité de circuits de pompe de charge (Pump1, ..., PumpM), comprenant un bloc de tri (11) recevant une pluralité de requêtes de puissance et capable de fournir un signal de tri (ORD) des requêtes de puissance afin d'actionner ladite pluralité de circuits de pompe de charge (Pump1, ... , PumpM M) et afin de distribuer les tensions d'alimentation appropriées (Vhigh1, ..., VhighN; Vneg1, ..., VnegN) à ladite pluralité de modules de mémoire (Mod1, ..., ModN),
**caractérisée en ce que** ledit bloc de tri (11) est connecté de manière bidirectionnelle à ladite pluralité de modules de mémoire (Mod1, ..., ModN), reçoit lesdites requêtes de puissance de ladite pluralité de modules de mémoire et fournit ledit signal de tri sur base d'une échelle de priorité.

2. Architecture de distribution de tension d'alimentation selon la revendication 1, **caractérisée en ce qu'**elle comprend également un bloc de commutation (12) connecté à ladite pluralité de modules de mémoire (Mod1, ..., ModN) via un bus bidirectionnel (6) et audit bloc de tri (11) pour recevoir au niveau de son entrée ledit signal de tri (ORD).

3. Architecture de distribution de tensions d'alimentation selon la revendication 2, **caractérisée en ce que** ledit bloc de tri (11) reçoit, via ledit bus bidirectionnel (6), un signal de requête de puissance (PSreq) d'un module de mémoire de ladite pluralité de modules (Mod1, ..., ModN) et un signal d'attribution de requête (PSgrn) et il est connecté à :
- un bus d'identification (Psidfy) de l'opération requise ; et
- un bus de priorité (Psrqpry) du signal de requête (Psreq).

4. Architecture de distribution de tensions d'alimentation selon la revendication 3, **caractérisée en ce que** ledit bloc de commutation (12) reçoit au niveau de son entrée lesdits signaux de requête de puissance (Psreq) et envoie ledit signal d'attribution de requête (PSgrn) et il est connecté audit bus d'identification (Psidfy) et audit bus de priorité (Psrqpry).

5. Architecture de distribution de tensions d'alimentation selon la revendication 4, **caractérisée en ce que** ledit bloc de commutation (12) est également connecté de manière bidirectionnelle à une pluralité de décodeurs de requête (13) à laquelle il fournit ledit signal de requête de puissance (PSreq) et de laquelle il reçoit ledit signal d'attribution de requête (PSgrn), ledit bloc de commutation (12) étant également connecté à ladite pluralité de décodeurs de requête (13) via ledit bus d'identification (PSidfy).

6. Architecture de distribution de tensions d'alimentation selon la revendication 5, **caractérisée en ce que** ladite pluralité de décodeurs de requête (13) est connectée d'une manière bidirectionnelle multiplexée à une pluralité de circuits conducteurs (14), connectée à son tour, via un autre bus bidirectionnel (5), à ladite pluralité de circuits de pompe de charge (Pump1, - ., PumpM),

7. Architecture de distribution de tensions d'alimentation selon la revendication 6, **caractérisée en ce que** ladite pluralité de décodeurs de requête (13) fournit via ledit autre bus bidirectionnel (5) les signaux suivants :
- un signal d'activation (pump_pwd) d'un circuit de pompe de charge correspondant ; et
- un signal de mode d'attente (pump_stby) d'un circuit de pompe de charge correspondant

8. Architecture de distribution de tensions d'alimentation selon la revendication 7, **caractérisée en ce que** ladite pluralité de décodeurs de requête (13) reçoit via un autre bus bidirectionnel (5) un signal de validité (pump_valid), pour fournir des informations selon lesquelles la pompe de charge a atteint la valeur recherchée.

9. Architecture de distribution de tensions d'alimentation selon la revendication 8, **caractérisée en ce que** ladite pluralité de circuits conducteurs (14) gère les conditions de coupure d'alimentation et d'attente de ladite pluralité de circuits de pompe de charge (Pump1, ... , PumpM) en limitant lesdites requêtes de puissance réalisées par chaque circuit de pompe de charge sous ladite valeur la plus élevée permise.

10. Architecture de distribution de tensions d'alimentation selon la revendication 6, **caractérisée en ce qu'**elle est configurable par logiciel.

11. Architecture de distribution de tensions d'alimentation selon la revendication 1, **caractérisée en ce que** ledit bloc de tri (11) traite lesdites requêtes de puissance reçues de ladite pluralité de modules (Mod1, ... , ModN) sur base des règles suivantes :
- état de la requête (requête étant déjà active ou nouvelle requête) ;
- informations de priorité ;
- position d'un module qui a réalisé ladite requête de puissance..

12. Architecture de distribution de tensions d'alimentation selon la revendication 11, **caractérisée en ce que** lesdites règles comprennent une classification de priorité des requêtes reçues des différents modules de ladite pluralité de modules de mémoire (Mod1, .... , ModN)

13. Architecture de distribution de tensions d'alimentation selon la revendication 1, **caractérisée en ce qu'**elle traite lesdites requêtes de puissance reçues de ladite pluralité de modules de mémoire (Mod1, ..., ModN) en un seul coup d'un signal d'horloge.
